# DEMANDE DE BREVET EUROPEEN

(11) **EP 4 394 642 A1**
(43) Date de publication de la demande: **03.07.2024**
(21) Numéro de dépôt: 23219104.9
(22) Date de dépôt: 21.12.2023
(51) Int. Cl.: G06F 30/20

(54) **SYSTÈME INFORMATIQUE DE VALIDATION FORMELLE D'UN SYSTÈME PHYSIQUE EN INGÉNIERIE DES SYSTÈMES, PROCÉDÉ ET PROGRAMME D'ORDINATEUR CORRESPONDANTS**

(30) Priorité: 31.12.2022 FR 2214740
(71) Demandeur: Alten, 92100 Boulogne-Billancourt (FR)
(72) Inventeur: RIFFARD, Antonin, 92100 Boulogne-Billancourt (FR)
(74) Mandataire: Bonnet, Michel

(57) **Abrégé**

Ce système informatique de validation formelle d'un système physique comporte un espace de définition du système physique par enregistrement de spécifications techniques (32) et une plate-forme logicielle (16). Celle-ci comporte un module fonctionnel (18) de génération de premiers modèles de validation à partir des spécifications techniques et de propriétés de validation (P1, ..., PN), ainsi qu'un module fonctionnel solveur (20) conçu pour appliquer au moins un solveur (S2, S3) non applicable aux premiers modèles de validation. Pour chaque solveur non applicable aux premiers modèles de validation, la plate-forme logicielle comporte un module fonctionnel (24, 26) de génération de requêtes exécutables par ce solveur pour la vérification des propriétés de validation. Elle comporte en outre une interface (UI₂₀) dédiée à la sélection d'un solveur parmi ledit au moins un solveur.

## Description

La présente invention concerne un système informatique pour la validation formelle d'un système physique électronique ou électromécanique définissable par modélisation selon un principe d'ingénierie des systèmes. Elle concerne également un procédé et un programme d'ordinateur correspondants.

En ingénierie des systèmes, il est bien connu de modéliser logiciellement et le plus fidèlement possible un système « multiphysique », c'est-à-dire un système physique électronique ou électromécanique complexe, pour le tester ensuite sur la vérification de propriétés de validation prédéfinies. Ces tests permettent de le valider, ou pas, avant de le perfectionner et le produire industriellement. Il peut s'agir de tout type de système, tel qu'un avion, un ordinateur, un système d'atterrissage pour avion, un système de signalisation d'une cabine d'aéronef, etc.

Les propriétés de validation qui sont testées sont généralement définies en termes :
- de cohérence : y a-t-il des contradictions dans les spécifications du modèle du système physique, que ce soit d'une façon globale ou locale ?
- de complétude : tous les comportements possibles du système physique ou d'un sous-ensemble du système physique, c'est-à-dire toutes les sorties possibles du système physique ou de ce sous-ensemble, quelles que soient les entrées, sont-ils prévus dans le modèle ?
- voire même éventuellement d'atteignabilité ou, au contraire, de restriction : un ensemble de valeurs données peut-il être atteint par les sorties possibles du système physique ou d'un sous-ensemble du système physique, ou au contraire inaccessible ?

L'invention s'applique plus particulièrement à un système informatique comportant un processeur, des moyens de stockage et une plate-forme logicielle constituée de plusieurs modules fonctionnels stockés dans les moyens de stockage et exécutables par le processeur, dans lequel :
- les moyens de stockage comportent un espace de définition du système physique par enregistrement d'un ensemble structuré de spécifications techniques exprimées dans un langage de modélisation prédéterminé ; et
- la plate-forme logicielle comporte un module fonctionnel de génération de premiers modèles de validation à partir de l'ensemble structuré de spécifications techniques et de propriétés de validation.

La plate-forme logicielle peut en outre comporter un module fonctionnel solveur d'application d'un éventuel premier solveur aux premiers modèles de validation engendrés, pour une vérification des propriétés de validation de l'ensemble structuré de spécifications techniques à partir des premiers modèles de validation.

Comme enseigné dans l'article de Pinquié et al, intitulé « Property Model Methodology: a case study with Modelica », publié dans Proceedings of Tools and Methods of Compétitive Engineering le 9 mai 2016, l'ensemble structuré de spécifications techniques définissant le système physique est avantageusement exprimé selon une méthodologie PMM (de l'anglais « Property Model Methodology ») selon laquelle des entrées et sorties du système physique sont liées entre elles par des relations logiques de causes à effets formalisant le respect de propriétés données. Ces relations logiques prennent la forme de conditions PBR (de l'anglais « Property-Based Requirements »). Les propriétés de validation précitées, cohérence, complétude et/ou atteignabilité-restriction, sont alors testées sur tout ou partie des conditions PBR du système physique.

Comme enseigné dans ce même document, le langage de modélisation prédéterminé peut être Modelica (marque déposée), par exemple dans l'environnement logiciel libre OpenModelica (marque déposée), dans l'environnement logiciel propriétaire Dymola (marque déposée) ou autre. Dans ce cas, l'environnement logiciel impose au mieux un solveur compatible spécifiquement conçu pour recevoir en entrée les premiers modèles de validation engendrés sous OpenModelica, Dymola ou autre. Le résultat de la validation formelle est donc nécessairement limité par le solveur imposé. Parfois même il n'existe tout simplement pas d'outil solveur pour valider formellement les spécifications.

En variante, il est possible de définir et valider formellement le système physique à l'aide du langage de modélisation Simulink (marque déposée) dans l'environnement logiciel Matlab (marque déposée). Mais dans ce cas également, l'environnement logiciel impose un solveur compatible spécifiquement conçu pour recevoir en entrée les premiers modèles de validation engendrés sous Matlab, en l'occurrence le solveur SLDV (de l'anglais « SimuLink Design Verifier »). Le résultat de la validation formelle est là encore limité par le solveur imposé.

Il peut ainsi être souhaité de prévoir un système informatique, pour la validation formelle d'un système physique électronique ou électromécanique définissable par modélisation selon un principe d'ingénierie des systèmes, qui permette de s'affranchir d'au moins une partie des problèmes et contraintes précités.

Il est donc proposé un système informatique, pour la validation formelle d'un système physique électronique ou électromécanique définissable par modélisation selon un principe d'ingénierie des systèmes, comportant un processeur, des moyens de stockage et une plate-forme logicielle constituée de plusieurs modules fonctionnels stockés dans les moyens de stockage et exécutables par le processeur, dans lequel :
- les moyens de stockage comportent un espace de définition du système physique par enregistrement d'un ensemble structuré de spécifications techniques exprimées dans un langage de modélisation prédéterminé ;
- la plate-forme logicielle comporte un module fonctionnel de génération de premiers modèles de validation à partir de l'ensemble structuré de spécifications techniques et de propriétés de validation ;
dans lequel :
- la plate-forme logicielle comporte un module fonctionnel solveur conçu pour appliquer au moins un solveur non applicable aux premiers modèles de validation ;
- pour chaque solveur non applicable aux premiers modèles de validation, la plate-forme logicielle comporte un module fonctionnel de génération, à partir de l'ensemble structuré de spécifications techniques, de requêtes exécutables par ce solveur pour la vérification des propriétés de validation de l'ensemble structuré de spécifications techniques ; et
- la plate-forme logicielle comporte en outre une interface, associée au module fonctionnel solveur, dédiée à la sélection d'un solveur parmi ledit au moins un solveur.

Ainsi, en fournissant une plate-forme logicielle capable d'intégrer de cette façon au moins un solveur sélectionnable non applicable aux premiers modèles de validation, pour un même ensemble structuré de spécifications techniques exprimées dans un langage de modélisation prédéterminé, le système informatique proposé permet d'exploiter une grande diversité de spécifications en proposant une souplesse dans leur validation formelle par solveur, sans être lié à un solveur spécifique qui serait dépendant du langage de modélisation choisi et imposé par ce dernier ou sans être entravé par un environnement logiciel sans outil solveur. Le module fonctionnel solveur devient en quelque sorte « universel » et ouvert à autant de solveurs que souhaité.

De façon optionnelle, le module fonctionnel solveur est également conçu pour proposer un premier solveur applicable aux premiers modèles de validation, pour une vérification des propriétés de validation de l'ensemble structuré de spécifications techniques à partir des premiers modèles de validation. L'interface est alors dédiée à la sélection d'un solveur parmi le premier solveur et ledit au moins un solveur non applicable aux premiers modèles de validation.

Le module fonctionnel solveur prend ainsi toute sa dimension de solveur universel apte à exploiter au mieux le langage de modélisation prédéterminé dans lequel sont exprimées les spécifications techniques.

De façon optionnelle également, la plate-forme logicielle comporte, pour chaque autre solveur que le premier solveur, un module fonctionnel de traduction d'un résultat de la vérification des propriétés de validation de l'ensemble structuré de spécifications techniques fourni par cet autre solveur en un résultat dans un format tel qui aurait été fourni par le premier solveur à partir de l'ensemble structuré de spécifications techniques pour la vérification des mêmes propriétés de validation de l'ensemble structuré de spécifications techniques.

De façon optionnelle également, chaque solveur est conçu pour produire une valeur booléenne de vérification de chaque propriété de validation de l'ensemble structuré de spécifications techniques indiquant si cette propriété de validation est vérifiée ou non pour l'ensemble structuré de spécifications techniques.

De façon optionnelle également, l'ensemble structuré de spécifications techniques est enregistré dans l'espace de définition du système physique sous une forme comportant au moins :
- un dictionnaire d'entrées du système physique prenant chacune la forme d'une paire formée d'une clé et d'une valeur associée à cette clé ; et
- un dictionnaire de sorties du système physique prenant chacune la forme d'une paire formée d'une clé et d'une valeur associée à cette clé, chaque sortie étant en outre associée à une liste d'au moins une relation logique de cause à effet formalisant le respect d'une propriété donnée.

De façon optionnelle également, pour au moins l'un dudit au moins un solveur non applicable aux premiers modèles de validation, le module fonctionnel de génération, à partir de l'ensemble structuré de spécifications techniques, de requêtes exécutables par ce solveur pour la vérification des propriétés de validation de l'ensemble structuré de spécifications techniques comporte :
- un sous-module fonctionnel de traduction des spécifications techniques dans un format commun d'interprétation prédéterminé autre que le langage de modélisation prédéterminé ;
- un sous-module fonctionnel de génération de deuxièmes modèles de validation à partir de l'ensemble structuré de spécifications techniques exprimées dans le format commun d'interprétation prédéterminé et des propriétés de validation ; et le cas échéant
- un sous-module fonctionnel de génération, à partir des deuxièmes modèles de validation, desdites requêtes exécutables par ce solveur pour la vérification des propriétés de validation de l'ensemble structuré de spécifications techniques.

De façon optionnelle également, pour au moins l'un dudit au moins un solveur non applicable aux premiers modèles de validation, le module fonctionnel de génération, à partir de l'ensemble structuré de spécifications techniques, de requêtes exécutables par ce solveur pour la vérification des propriétés de validation de l'ensemble structuré de spécifications techniques comporte :
- un sous-module fonctionnel de transformation de l'ensemble structuré de spécifications techniques exprimées dans le langage de modélisation prédéterminé en un ensemble d'équations à arbres syntaxiques ; et
- un sous-module fonctionnel de génération, à partir de l'ensemble d'équations à arbres syntaxiques, desdites requêtes exécutables par ce solveur pour la vérification des propriétés de validation de l'ensemble structuré de spécifications techniques.

De façon optionnelle également, le sous-module fonctionnel de transformation comporte un analyseur logiciel syntaxique et lexical.

De façon optionnelle également, le module fonctionnel de génération de requêtes exécutables par ce solveur est implémenté en langage de programmation Python et l'analyseur syntaxique et lexical comporte l'outil Python Lex-Yacc.

Il est également proposé un procédé de validation formelle d'un système physique électronique ou électromécanique définissable par modélisation selon un principe d'ingénierie des systèmes, comportant les étapes suivantes :
- modélisation du système physique par enregistrement, dans un espace de définition du système physique inclus dans des moyens de stockage, d'un ensemble structuré de spécifications techniques exprimées dans un langage de modélisation prédéterminé ;
- réception, par une plate-forme logicielle exécutée par un processeur ayant accès aux moyens de stockage, de l'ensemble structuré de spécifications techniques ;
- sélection, à l'aide d'une interface dédiée associée à un module fonctionnel solveur de la plate-forme logicielle, d'un solveur parmi :
   - un éventuel premier solveur de vérification des propriétés de validation de l'ensemble structuré de spécifications techniques à partir de premiers modèles de validation, et
   - au moins un autre solveur, non applicable aux premiers modèles de validation, pour lequel la plate-forme logicielle comporte un module fonctionnel de génération, à partir de l'ensemble structuré de spécifications techniques, de requêtes exécutables par cet autre solveur pour la vérification des propriétés de validation de l'ensemble structuré de spécifications techniques ;
- génération, par un module fonctionnel de la plate-forme logicielle, des premiers modèles de validation à partir de l'ensemble structuré de spécifications techniques et de propriétés de validation au moins lorsque l'éventuel premier solveur est sélectionné ; et
- exécution du solveur sélectionné pour la vérification des propriétés de validation de l'ensemble structuré de spécifications techniques.

Il est également proposé un programme d'ordinateur téléchargeable depuis un réseau de communication et/ou enregistré sur un support lisible par ordinateur et/ou exécutable par un processeur, caractérisé en ce qu'il comprend des instructions pour l'exécution des étapes d'un procédé de validation formelle d'un système physique selon l'invention, lorsque ledit programme est exécuté sur un ordinateur.

L'invention sera mieux comprise à l'aide de la description qui va suivre, donnée uniquement à titre d'exemple et faite en se référant aux dessins annexés dans lesquels :
- la figure 1 représente schématiquement la structure générale d'un système informatique de validation formelle d'un système physique, selon un mode de réalisation de l'invention,
- la figure 2 illustre les étapes successives d'un procédé de validation formelle d'un système physique, selon un mode de réalisation de l'invention,
- la figure 3 illustre les sous-étapes successives d'une étape de transformation de l'ensemble structuré de spécifications techniques exprimées dans le langage de modélisation prédéterminé, cette étape de transformation pouvant être prévue dans l'exécution du procédé de validation formelle de la figure 2, selon une première variante, et
- la figure 4 illustre un résultat intermédiaire possible de l'étape de transformation précitée, selon une deuxième variante.

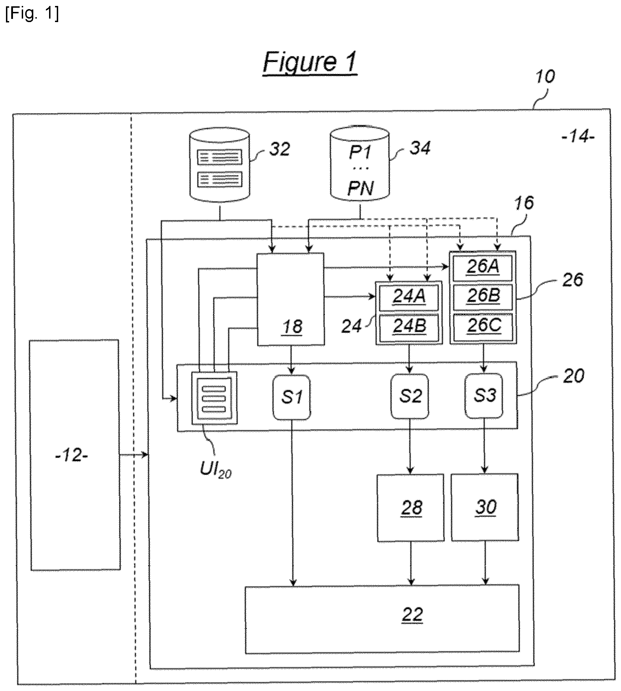

Le système informatique 10 représenté sur la figure 1, par exemple un ordinateur, comporte un processeur 12 associé de façon classique à des moyens de stockage 14, par exemple une mémoire RAM, pour le stockage de fichiers de données et de programmes d'ordinateurs exécutables par le processeur 12.

Parmi les programmes d'ordinateurs exécutables par le processeur 12, une plate-forme logicielle 16 constituée de plusieurs modules fonctionnels, par exemple ceux identifiés par les références 18, 20, 22, 24, 26, 28 et 30 dans l'exemple non limitatif de la figure 1, est stockée dans la mémoire 14. Le système informatique 10 tel qu'illustré sur la figure 1 comporte ainsi fonctionnellement plusieurs programmes d'ordinateurs que représentent les modules fonctionnels 18 à 30, ou plusieurs fonctions d'un même programme d'ordinateur que représente la plate-forme logicielle 16. On notera par ailleurs que les modules fonctionnels 18 à 30 sont présentés comme distincts, mais cette distinction est purement fonctionnelle. Ils pourraient tout aussi bien être regroupés selon toutes les combinaisons possibles en un ou plusieurs logiciels. Leurs fonctions pourraient aussi être au moins en partie micro programmées ou micro câblées dans des circuits intégrés dédiés. Ainsi, en variante, le système informatique 10 pourrait prendre la forme d'un dispositif électronique composé au moins partiellement de circuits numériques (sans programme d'ordinateur) pour la réalisation des mêmes actions.

Le système informatique 10 est conçu pour la validation formelle d'un système physique électronique ou électromécanique définissable par modélisation selon un principe d'ingénierie des systèmes. A cet effet, la mémoire 14 comporte un espace de définition du système physique par enregistrement d'un ensemble structuré de spécifications techniques 32 exprimées dans un langage de modélisation prédéterminé. Ce langage de modélisation prédéterminé est par exemple Simulink qui permet, dans l'environnement logiciel Matlab, de proposer une représentation visuelle à l'aide de blocs fonctionnels logiquement interconnectés du système physique. Ce langage de modélisation prédéterminé peut aussi être Modelica, auquel cas l'ensemble structuré de spécifications techniques 32 est représenté différemment, par exemple sous la forme d'un système d'équations.

D'une façon générale il peut être considéré que, dans ces deux cas, l'ensemble structuré de spécifications techniques 32 comporte plusieurs dictionnaires qui peuvent être extraient des représentations précitées, c'est-à-dire plusieurs collections d'objets non ordonnés ou plusieurs tableaux associatifs implémentables sous la forme de tables de hachage, comportant au moins :
- un dictionnaire qui contient toutes les entrées du système physique, chaque entrée prenant la forme d'une paire formée d'une clé (i.e. le nom de l'entrée) et d'une valeur associée à cette clé (i.e. le type de l'entrée) ; et
- un dictionnaire qui contient toutes les sorties du système physique, chaque sortie prenant la forme d'une paire formée d'une clé (i.e. le nom de la sortie) et d'une valeur associée à cette clé (i.e. le type de la sortie), chaque sortie étant en outre associée à une liste d'au moins une relation logique de cause à effet formalisant le respect d'une propriété donnée du système physique.

Comme indiqué précédemment, en méthodologie PMM chaque relation logique de chaque sortie du système physique prend la forme d'une condition PBR. Une condition PBR d'une sortie peut relier une ou plusieurs entrées à cette sortie du système. Elle peut aussi relier une ou plusieurs autres sorties à cette sortie de telle sorte que cela crée une arborescence de conditions PBR, voire même une structure plus complexe, par exemple à boucles, de conditions PBR.

Un exemple simple de dictionnaire d'entrées est exprimable sous la forme {'a' : 'Real', 'b' : 'Bool'} pour définir deux entrées a et b de types respectifs réel et booléen. Un exemple simple de dictionnaire de sorties est exprimable sous la forme {'y' : ('Real', [('PBRy1.cause', 'PBRy1.effect'), ('PBRy2.cause', 'PBRy2.effect')]), 'z' : ('Bool', [('PBRz1.cause', 'PBRz1.effect')]),} pour définir deux sorties y et z de types respectifs réel et booléen avec deux conditions PBR pour y et une condition PBR pour z.

De façon optionnelle, l'ensemble structuré de spécifications techniques 32 peut comporter au moins un dictionnaire supplémentaire, notamment pour définir des entrées ou sorties de types structurés complexes tels que des énumérations. Par exemple, pour définir un type d'énumération représentant la couleur, on peut écrire : {'Couleur' : '(Bleu) (Rouge) (Vert)'}.

Les propriétés de validation P1, ..., PN que l'on souhaite vérifier par solveur sur le système physique tel que défini par l'ensemble structuré de spécifications techniques 32 sont par exemple prédéfinies et enregistrées sous la référence 34 dans la mémoire 14. Elles portent chacune sur tout ou partie des conditions PBR précitées. Comme indiqué précédemment, il peut s'agir de propriétés de cohérence, complétude et/ou atteignabilité-restriction. En termes de cohérence, celle-ci peut varier selon les conditions PBR prises en compte : de la vérification d'une cohérence globale, lorsque toutes les conditions PBR du système physique sont prises en compte simultanément, à la vérification de cohérences locales de différentes natures, lorsque seulement certaines conditions PBR sont prises en compte simultanément, telles que toutes les conditions PBR d'une même sortie, un ensemble de conditions PBR prises en compte deux à deux ou plus généralement n à n (n étant un entier supérieur à 2), etc. Le détail de ces propriétés ne fait pas l'objet de la présente invention et ne sera donc pas décrit. En variante, elles peuvent aussi être définies en ligne, c'est-à-dire avant chaque sollicitation d'un solveur, via une interface homme-machine par exemple.

Pour tester les propriétés de validation P1, ..., PN sur l'ensemble structuré de spécifications techniques 32, le module fonctionnel 18 de la plate-forme logicielle 16 est conçu pour engendrer des premiers modèles de validation à partir de l'ensemble structuré de spécifications techniques 32 et des propriétés de validation P1, ..., PN.

Par exemple dans l'environnement Matlab, le module fonctionnel 18 peut être une boîte à outils logicielle développée selon la méthodologie PMM, capable de fournir de façon plus ou moins automatisée les premiers modèles de validation en langage de modélisation Simulink. Il existe des boîtes à outils complètement automatisées, mais elles sont généralement propriétaires, et d'autres environnements plus libres nécessitant l'intervention d'un programmeur. Dans tous les cas, les modèles de validation fournis sont aptes à être reçus par le solveur SLDV.

De même dans l'environnement OpenModelica, Dymola ou équivalent, le module fonctionnel 18 peut être une boîte à outils logicielle développée selon la méthodologie PMM, capable de fournir de façon plus ou moins automatisée les premiers modèles de validation en langage de modélisation Modelica. Les modèles de validation fournis sont alors aptes à être reçus par un éventuel solveur compatible spécifiquement conçu pour recevoir en entrée des premiers modèles de validation engendrés sous OpenModelica, Dymola ou équivalent.

L'ensemble structuré de spécifications techniques 32 sur lequel il est souhaité de vérifier les propriétés de validation P1, ..., PN peut être relativement simple, c'est-à-dire notamment sans contraintes telles que des hypothèses particulières qui contraignent ses entrées dans certaines positions, la prise en compte d'un état qui peut évoluer dans le temps ou des dépendances entre conditions PBR. Mais il peut aussi être rendu plus complexe par l'ajout de l'une ou plusieurs de ces trois contraintes, selon toutes les combinaisons possibles au nombre de huit, à prendre en compte ou pas dans la vérification des propriétés de validation P1, ..., PN.

Pour vérifier les propriétés de validation P1, ..., PN de l'ensemble structuré de spécifications techniques 32 à partir des premiers modèles de validation qui peuvent être engendrés par le module fonctionnel 18, le module fonctionnel 20 de la plate-forme logicielle 16 est conçu pour appliquer de façon optionnelle un éventuel premier solveur S1 compatible avec ces premiers modèles de validation. Conformément aux principes généraux de la présente invention, il est en outre conçu pour appliquer au moins un autre solveur S2, S3 que ce premier solveur S1, chaque autre solveur étant non applicable aux premiers modèles de validation, et est de ce fait associé à une interface UI₂₀ dédiée à la sélection d'un solveur parmi l'éventuel premier solveur S1 et ledit au moins un autre solveur S2, S3. Dans l'exemple de la figure 1, trois solveurs S1, S2 et S3 sont proposés et sélectionnables. Ils peuvent être intégrés dans la plate-forme logicielle 16 ou accessibles par elle sur un serveur externe, notamment via Internet. Les autres solveurs peuvent être par exemple pour au moins une partie d'entre eux des solveurs SMT, c'est-à-dire compatibles avec la bibliothèque logicielle SMT-LIB, tel que CVC4 qui se présente avantageusement sous la forme d'un logiciel libre.

En variante, un seul solveur pourrait être proposé à la sélection, i.e. un seul autre solveur non applicable aux premiers modèles de validation, lorsque l'environnement logiciel de génération des premiers modèles de validation ne propose aucun premier solveur S1 compatible.

En variante, deux solveurs seulement pourraient être proposés à la sélection, i.e. le premier solveur S1 compatible avec les premiers modèles de validation et un seul autre solveur non applicable, ou deux autres solveurs non applicables, aux premiers modèles de validation.

En variante également, plus de trois solveurs pourraient être proposés à la sélection, i.e. le premier solveur S1 et au moins trois autres solveurs non applicables, ou au moins quatre autres solveurs non applicables, aux premiers modèles de validation.

Dans le cas de premiers modèles de validation engendrés en langage de modélisation Simulink sous Matlab, le premier solveur S1 est SLDV. Dans le cas de premiers modèles de validation engendrés en langage de modélisation Modelica, l'éventuel premier solveur S1 doit être un solveur compatible avec les environnements OpenModelica, Dymola ou équivalent.

Pour obtenir les résultats des vérifications réalisées par l'un ou l'autre des solveurs du module fonctionnel solveur 20, le module fonctionnel 22 de la plate-forme logicielle 16 est conçu pour réaliser un affichage de ces résultats.

D'une façon assez générale, un solveur résout un problème de satisfaisabilité, par exemple un problème de satisfaisabilité booléenne ou problème SAT lorsqu'il s'agit d'un solveur SAT ou un problème de satisfaisabilité des théories ou problème SMT lorsqu'il s'agit d'un solveur SMT, selon lequel il s'agit de déterminer s'il existe une assignation des variables d'une formule de logique propositionnelle fournie en entrée du solveur qui rend cette formule vraie. Dans le contexte de la présente invention, la formule de logique propositionnelle est directement corrélée à l'une des propriétés de validation P1, ..., PN de l'ensemble structuré de spécifications techniques 32. Le solveur sélectionné à l'aide de l'interface UI₂₀ produit ainsi une valeur booléenne SAT/UNSAT de vérification de chaque propriété de validation P1, ..., PN de l'ensemble structuré de spécifications techniques 32 indiquant si cette propriété de validation est vérifiée ou non pour l'ensemble structuré de spécifications techniques 32. Il produit la valeur SAT avec un exemple qui rend la proposition vraie, ou la valeur UNSAT dans le cas où la proposition n'est jamais vraie. Certains solveurs fournissent une valeur UNKNOWN lorsqu'ils sont confrontés à une situation dans laquelle ils ne peuvent pas prendre de décision booléenne.

En pratique, c'est la négation de chaque propriété de validation P1, ..., PN de l'ensemble structuré de spécifications techniques 32 qui est fournie au solveur sélectionné pour que ce dernier puisse retourner un exemple associé à chaque propriété de validation non vérifiée. Notamment, pour une propriété de cohérence, c'est un exemple d'incohérence qui est retourné. Dans le cas où c'est le solveur S1 qui est sélectionné, ce sont directement les négations des premiers modèles de validation engendrés par le module fonctionnel 18 qui sont fournies en entrée du solveur S1 et ce dernier est apte à renvoyer un exemple associé à chaque modèle de validation non vérifié.

Le module fonctionnel d'affichage 22 est plus précisément conçu pour produire un affichage des résultats dans un format éventuellement spécifique au solveur S1.

Ainsi, lorsque c'est le solveur S1 qui est sélectionné via l'interface UI₂₀ du module fonctionnel solveur 20, ce sont les premiers modèles de validation du module fonctionnel 18 qui sont directement traités par le module fonctionnel solveur 20 et ce sont les résultats du module fonctionnel solveur 20 qui sont directement affichés par le module fonctionnel 22.

En revanche, lorsque c'est l'un des autres solveurs S2, S3 qui est sélectionné via l'interface UI₂₀ du module fonctionnel solveur 20, conformément aux principes généraux de la présente invention, un traitement doit être effectué sur les premiers modèles de validation fournis par le module fonctionnel 18 (selon les deux flèches horizontales en traits pleins représentées en sortie du module fonctionnel 18) , ou sur les données de l'ensemble structuré de spécifications techniques 32 et les propriétés de validation P1, ..., PN (selon les flèches représentées en pointillés), pour obtenir des requêtes exécutables par cet autre solveur. Ainsi, pour chaque autre solveur S2 ou S3 que le premier solveur S1, la plate-forme logicielle 16 comporte un module fonctionnel de génération, à partir de l'ensemble structuré de spécifications techniques 32, de requêtes exécutables par cet autre solveur S2 ou S3 pour la vérification des propriétés de validation P1, ..., PN de l'ensemble structuré de spécifications techniques 32.

Les deux modules fonctionnels 24 et 26 de la plate-forme logicielle 16 sont donc respectivement conçus pour engendrer de cette façon des requêtes exploitables par les deux autres solveurs S2 et S3.

De même, lorsque c'est l'un des autres solveurs S2, S3 qui est sélectionné via l'interface UI₂₀ du module fonctionnel solveur 20, et lorsque les résultats fournis par le premier solveur S1 au module fonctionnel d'affichage 22 sont conformes à un certain format spécifique au solveur S1, il peut être avantageux de prévoir une traduction des résultats fournis vers ce format spécifique avant de les transmettre au module fonctionnel d'affichage 22. Ainsi, pour chaque autre solveur S2 ou S3 que le premier solveur S1, la plate-forme 16 comporte un module fonctionnel de traduction d'un résultat de la vérification des propriétés de validation P1, ..., PN de l'ensemble structuré de spécifications techniques 32 fourni par cet autre solveur S2 ou S3 en un résultat dans un format tel qui aurait été fourni par le premier solveur S1 à partir de l'ensemble structuré de spécifications techniques 32 pour la vérification des mêmes propriétés de validation P1, ..., PN de l'ensemble structuré de spécifications techniques 32.

Les deux modules fonctionnels 28 et 30 de la plate-forme logicielle 16 sont donc respectivement conçus pour traduire de cette façon les résultats fournis par les deux autres solveurs S2 et S3. Ils ne seront pas davantage détaillés. En effet, il est astucieux de prévoir un module fonctionnel de traduction des résultats de chaque autre solveur que le premier solveur S1, pour uniformiser la présentation des résultats avant de les afficher quel que soit le solveur qui les a fournis. En revanche, à partir du moment où l'idée d'un tel module fonctionnel de traduction est suggérée pour un autre solveur que le premier solveur S1, il est très facile pour l'homme du métier de le programmer sur la base d'une connaissance a *priori* du format des données de sortie du premier solveur S1 et de celui de cet autre solveur, d'autant plus que les données de sorties reprennent généralement toutes le principe d'un résultat logique de type SAT (avec exemple éventuel), UNSAT et éventuellement UNKNOWN.

Différentes configurations peuvent être envisagées pour chaque module fonctionnel de génération de requêtes exécutables lié à chaque autre solveur. Cela dépend en particulier du langage de modélisation prédéterminé et de son environnement logiciel, ainsi que du solveur considéré.

Selon une première configuration possible illustrée à titre d'exemple non limitatif dans la figure 1 pour le solveur S2, le module fonctionnel 24 de génération de requêtes exécutables par S2 comporte deux sous-modules fonctionnels :
- un sous-module fonctionnel 24A de transformation de l'ensemble structuré de spécifications techniques 32 exprimées dans le langage de modélisation prédéterminé (par exemple Simulink ou Modelica) en un ensemble de fonctions ou d'équations à arbres syntaxiques, et
- un sous-module fonctionnel 24B de génération, à partir de l'ensemble de fonctions ou d'équations à arbres syntaxiques, des requêtes exécutables par le solveur S2 (par exemple selon des termes conformes à SMT-LIB) pour la vérification des propriétés de validation P1, ..., PN de l'ensemble structuré de spécifications techniques 32.

Dans le cas où le langage de modélisation prédéterminé est Modelica sous OpenModelica, la transformation exécutée par le sous-module fonctionnel 24A peut être définie sous OMPython pour une expression de l'ensemble d'équations à arbres syntaxiques sous Python. Elle comporte alors avantageusement une analyse logicielle syntaxique et lexicale réalisée à l'aide de l'outil Python Lex-Yacc. D'une façon générale, le module fonctionnel 24 de génération de requêtes exécutables par S2 est alors implémenté en langage de programmation Python.

Selon une deuxième configuration possible illustrée à titre d'exemple non limitatif dans la figure 1 pour le solveur S3, le module fonctionnel 26 de génération de requêtes exécutables par S3 comporte trois sous-modules fonctionnels :
- un sous-module fonctionnel 26A de traduction des spécifications techniques 32 dans un format commun d'interprétation prédéterminé (par exemple Python) autre que le langage de modélisation prédéterminé,
- un sous-module fonctionnel 26B de génération de deuxièmes modèles de validation (par exemple sous Python) à partir de l'ensemble structuré de spécifications techniques 32 exprimées dans le format commun d'interprétation prédéterminé et des propriétés de validation P1, ..., PN, et le cas échéant
- un sous-module fonctionnel 26C de génération, à partir des deuxièmes modèles de validation, des requêtes exécutables par le solveur S3 pour la vérification des propriétés de validation P1, ..., PN de l'ensemble structuré de spécifications techniques 32.

Il se peut que les deuxièmes modèles de validation soient directement exécutables par le solveur S3, auquel cas le troisième sous-module 26C n'est pas nécessaire.

On notera par ailleurs que les première et deuxième configurations ci-dessus ne sont pas incompatibles. Le sous-module 24A est par exemple inclus dans ou équivalent au sous-module 26A, tandis que le sous-module 24B peut dans certains cas être considéré comme équivalent au(x) sous-module(s) 26B et/ou 26C.

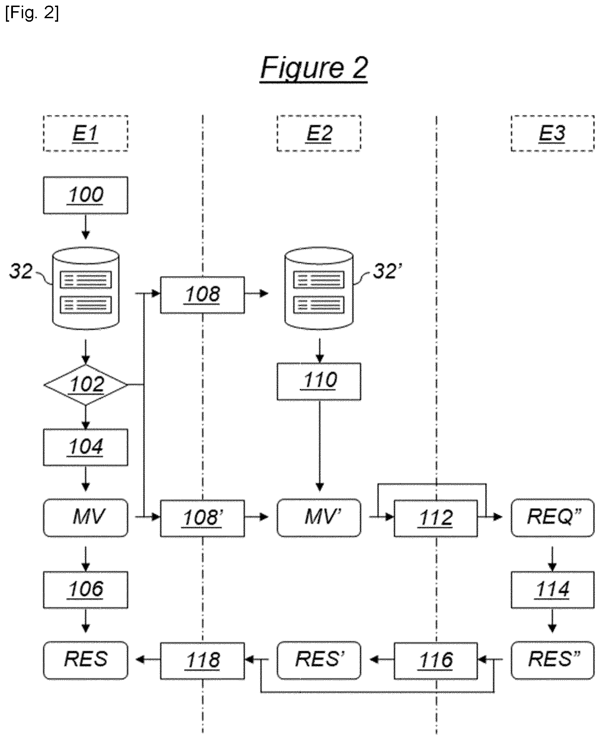

Un procédé de validation formelle d'un système physique électronique ou électromécanique définissable par modélisation selon un principe d'ingénierie des systèmes à l'aide du système informatique 10 de la figure 1 va maintenant être détaillé en référence à la figure 2.

Au cours d'une première étape 100 exécutée dans un environnement logiciel E1 de modélisation, un ensemble structuré de spécifications techniques 32 du système physique, exprimées dans un langage de modélisation prédéterminé compatible avec l'environnement E1, est enregistré en mémoire 14. Comme indiqué précédemment, l'environnement logiciel E1 est par exemple Matlab et le langage de modélisation prédéterminé est alors Simulink, ou l'environnement logiciel E1 est par exemple OpenModelica ou Dymola et le langage de modélisation prédéterminé est alors Modelica.

Au cours d'une étape suivante 102, l'interface utilisateur UI₂₀ du module solveur 20 propose à un utilisateur le choix entre plusieurs solveurs, notamment les solveurs S1, S2 et S3 dans l'exemple non limitatif de la figure 1. Parmi ces solveurs, le solveur S1 est apte à vérifier les propriétés de validation P1, ..., PN de l'ensemble structuré de spécifications techniques 32 à partir des premiers modèles de validation précités.

Si c'est le solveur S1 qui est choisi, le procédé de validation formelle passe donc à une étape 104 au cours de laquelle le module fonctionnel 18 de la plate-forme logicielle 16 exécutée par le processeur 12 ayant accès à la mémoire 14 traite l'ensemble structuré de spécifications techniques 32 pour engendrer, de façon connue en soi, des premiers modèles de validation MV à partir en outre des propriétés de validation précitées P1, ..., PN. Ces dernières peuvent être définies, soit au cours de l'étape 100, soit de façon totalement indépendante.

Puis le procédé de validation formelle passe à une étape 106 d'exécution du solveur S1 pour la vérification des propriétés de validation P1, ..., PN de l'ensemble structuré de spécifications techniques 32 à partir des premiers modèles de validation MV. Comme indiqué précédemment, ce sont les négations des premiers modèles de validation MV qui sont fournies en entrée du solveur S1 et ce dernier est apte à renvoyer un résultat RES sous la forme de réponses SAT, UNSAT ou UNKNOWN, un exemple pouvant alors être optionnellement associé à chaque réponse SAT, c'est-à-dire à chaque modèle de validation non vérifié.

Si c'est un autre solveur que le solveur S1 qui est choisi, c'est-à-dire un solveur non applicable aux premiers modèles de validation, par exemple le solveur S2 ou S3, le procédé de validation formelle passe à l'exécution de cet autre solveur pour la vérification des propriétés de validation P1, ..., PN de l'ensemble structuré de spécifications techniques 32. Mais cela ne se fait pas directement à partir des premiers modèles de validation MV. Conformément aux principes généraux de la présente invention, cela se fait par la génération, à partir de l'ensemble structuré de spécifications techniques 32, de requêtes REQ" exécutables par cet autre solveur pour la vérification des propriétés de validation P1, ..., PN de l'ensemble structuré de spécifications techniques 32.

Cette génération de requêtes REQ" comporte par exemple une étape 108 de traduction de l'ensemble structuré de spécifications techniques 32 dans un format commun d'interprétation prédéterminé, par exemple Python, d'un environnement logiciel E2 (i.e. celui de Python) autre que le langage de modélisation de l'environnement logiciel E1 qui a permis d'exprimer l'ensemble structuré de spécifications techniques 32. On obtient alors un ensemble structuré de spécifications techniques 32' traduites dans ce format commun d'interprétation prédéterminé, c'est-à-dire sous Python par exemple. L'étape 108 est exécutée par le sous-module 26A du module fonctionnel 26 ou par le sous-module 24A du module fonctionnel 24.

La génération de requêtes REQ" comporte par exemple en outre une étape 110 de génération de deuxièmes modèles de validation MV', par exemple sous Python, à partir de l'ensemble structuré de spécifications techniques 32' exprimées dans le format commun d'interprétation et des propriétés de validation P1, ..., PN. Cette étape est exécutée par le sous-module 26B du module fonctionnel 26 ou par le sous-module 24B du module fonctionnel 24. Pour l'exécution de cette étape, il est possible d'envisager un menu contextuel dédié à la validation formelle et pouvant être ouvert par l'utilisateur afin de choisir quelles propriétés de validation vérifier pour les spécifications techniques étudiées.

La génération de requêtes REQ" comporte par exemple en outre une étape 112 de génération des requêtes REQ" à partir des deuxièmes modèles de validation MV'. Les requêtes REQ" sont exprimées dans un environnement logiciel E3 qui est celui du solveur S2 ou S3 sélectionné. Cette étape est exécutée par le sous-module 26C du module fonctionnel 26 ou par le sous-module 24B du module fonctionnel 24. Elle est optionnelle. En effet, il peut arriver que les deuxièmes modèles de validation MV' soient en fait exprimés sous forme de requêtes directement exploitables par le solveur S2 ou S3 sélectionné, i.e. MV' = REQ", l'environnement logiciel E3 étant alors notamment le même que E2.

En variante, on notera que les deuxièmes modèles de validation MV' peuvent être engendrés directement par traduction des premiers modèles de validation MV, par exécution d'un module fonctionnel, équivalent aux modules 24 et 26 mais non représenté sur la figure 1, au cours d'une étape 108' se substituant aux étapes 108 et 110. Dans ce cas, l'étape 104 de génération des premiers modèles de validation MV doit être exécutée même si ce n'est pas le premier solveur S1 qui a été sélectionné à l'étape 102.

En variante également, on notera que l'étape 104 peut précéder l'étape 102 s'il est considéré que, quel que soit le choix de solveur réalisé à l'étape 102, il est nécessaire d'engendrer les premiers modèles de validation MV, notamment si c'est l'étape 108', et non la succession d'étapes 108 et 110, qui est exécutée pour l'obtention des deuxièmes modèles de validation MV' lorsqu'un autre solveur que S1 est choisi.

Suite à la succession d'étapes 108, 110 et 112, ou suite aux étapes 108 et 110, ou suite aux étapes 108' et 112, ou suite à l'étape 108', le procédé de validation formelle passe à une étape 114 d'exécution du solveur S2 ou S3 sélectionné pour la vérification des propriétés de validation P1, ..., PN de l'ensemble structuré de spécifications techniques 32 à partir des requêtes REQ". Comme indiqué précédemment, ce sont les négations des deuxièmes modèles de validation MV' qui sont fournies sous forme de requêtes en entrée du solveur S2 ou S3 sélectionné et ce dernier est apte à renvoyer un résultat RES" sous la forme de réponses SAT, UNSAT ou UNKNOWN, un exemple pouvant alors être optionnellement associé à chaque réponse SAT, c'est-à-dire à chaque modèle de validation non vérifié.

De façon optionnelle mais avantageuse, compte tenu du fait que les environnements logiciels E1, E2 et E3 sont potentiellement différents, le procédé de validation formelle peut en outre comporter au moins une étape de traduction du résultat RES" dans un format tel qui aurait été fourni par le premier solveur S1 dans l'environnement E1. Le résultat RES" est ainsi traduit en un résultat RES' conforme à l'environnement logiciel E2 au cours d'une étape 116 et le résultat RES' est traduit pour obtenir le résultat RES conforme à l'environnement logiciel E1 au cours d'une étape finale 118. En variante, notamment lorsque l'environnement E3 est E2, le résultat RES" peut être directement traduit en RES. Dans l'exemple non limitatif de la figure 1, les étapes 116 et 118 sont réalisées par exécution du module fonctionnel 28 ou 30, respectivement pour le solveur S2 ou S3.

Un premier exemple concret d'application de la présente invention va maintenant être détaillé. Il s'agit de pouvoir valider formellement un système physique modélisé dans le langage de modélisation Modelica sous environnement OpenModelica (i.e. environnement E1) à l'aide d'un solveur SMT, non inclus dans OpenModelica, sous un environnement de ce solveur compatible avec la bibliothèque logicielle SMT-LIB (i.e. environnement E3 différent de E1).

Le système physique est modélisé dans le langage Modelica au cours de l'étape 100.

Au cours de l'étape 102, l'utilisateur opte pour le solveur SMT non inclus dans OpenModelica, par exemple S2 ou S3. Les étapes 104 et 106 ne sont alors pas exécutées.

Au cours de l'étape 108, l'ensemble structuré de spécifications techniques 32 exprimées en langage Modelica est transformé en un ensemble d'équations à arbres syntaxiques pouvant lui-même être interprété à l'aide de la bibliothèque logicielle SMT-LIB. Cette transformation est réalisée sous environnement logiciel Python (i.e. l'environnement E2) qui permet de bénéficier de la bibliothèque logicielle OMPython pour interagir avec OpenModelica.

Les spécifications techniques se présentent sous la forme d'une structure de données contenant : le nom d'un fichier contenant les spécifications ; les sorties du système physique et leurs types ; les conditions PBR associées à chaque sortie. Cette description du système physique est rédigée par l'utilisateur. Elle peut aussi être au moins en partie automatisée, ce qui est possible si les spécifications sont rédigées en suivant certaines conventions.

Un exemple de description partielle de système physique est :

```
       Project_descriptor_exemple2 = {
          'file' : 'Exemple.mo',
          'PBRs' : {
            'signal_val' : ('Real', [
               ('Exemple. PBRSum.C','Exemple.PBRSum.D'),
               ('Exemple. PBRProd.C', 'Exemple.PBRProd.D'),
            ]),
            'threshold_crossed' : ('Bool', [
               ('Exemple.PBRCrossed.C','Exemple.PBRCrossed.D'),
            ]),
          },
}
```

Dans cet exemple, le fichier 'Exemple.mo' est lui-même un fichier en langage Modelica contenant des données de description du système physique considéré.

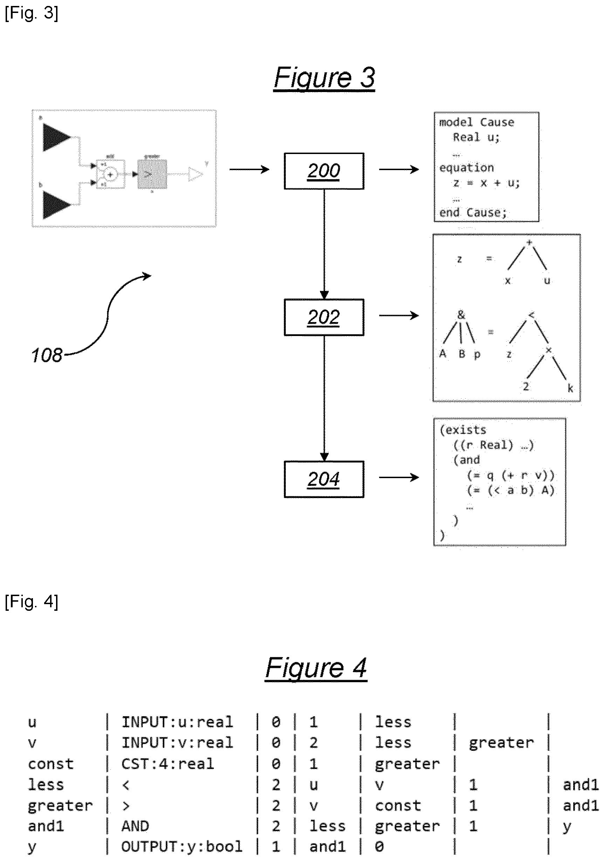

Dans cet exemple également, certaines données descriptives peuvent être représentées en blocs fonctionnels organisés visuellement, ce qui est par exemple le cas de la condition 'Exemple. PBRSum.C' qui est illustrée en partie supérieure gauche de la figure 3.

Comme par ailleurs illustré sur cette même figure, la transformation 108 comporte une première sous-étape éventuelle 200 de récupération d'une version instanciée (i.e. les causes et les effets de chaque condition PBR) de chaque fonction de la représentation en blocs fonctionnels, lorsque cette version instanciée n'est pas initialement disponible. La version instanciée d'une fonction est une version textuelle où tous les objets sont remplacés par la définition de la fonction dont ils dépendent. Elle est donc composée d'un ensemble de déclarations de variables et d'équations. Une telle version instanciée peut être obtenue, de façon connue en soi, directement en utilisant OMPython, notamment à l'aide de la commande « InstanciateModel ».

La transformation 108 comporte une deuxième sous-étape 202 d'analyse logicielle syntaxique et lexicale de ces fonctions instanciées. Cette sous-étape est réalisée à l'aide de l'outil Python Lex-Yacc qui permet de créer facilement des lexeurs et des parseurs. Le résultat obtenu est une liste d'équations exprimées dans un langage se présentant sous forme d'arbres syntaxiques, assez proche de la syntaxe des termes de la bibliothèque logicielle SMT-LIB.

Enfin, la transformation 108 comporte une troisième sous-étape 204 d'interprétation de cet ensemble d'équations sous forme d'arbres syntaxiques en une fonction SMT-LIB. Cette fois-ci, c'est la gestion native par SMT-LIB des équations et des quantificateurs existentiels qui aide à représenter les fonctions voulues sous la forme de spécifications techniques 32' traduites dans le format commun de l'environnement E2.

On notera que la représentation en arbres syntaxiques précitée ne peut théoriquement être obtenue que s'il n'y a pas de boucles dans les conditions PBR de l'ensemble structuré de spécifications techniques 32. De manière générale, ces boucles ne sont pas utilisées puisque cela engendre des boucles algébriques, c'est-à-dire des boucles de dépendances qui sont insolubles. Pour éviter de telles boucles algébriques, il est possible d'avoir recours à des blocs de mémoire, ce qui permet de supprimer les dépendances cycliques en ajoutant des délais. Ce recours aux blocs de mémoire n'est cependant toujours pas compatible avec la représentation sous forme d'arbre. Pour résoudre ce nouveau problème, chaque bloc de mémoire pourrait être transformé en une sortie du système (sa valeur à l'état courant) et une entrée du système (sa valeur à l'état précédent). Mais cela peut poser des problèmes lors de la validation formelle, puisque cela ajoute des entrées sans lien entre elles, alors qu'elles en ont potentiellement un. Par exemple, une fonction f(a) = a + pre(a) + pre(a) pourrait devenir f(a, p1, p2) = a + p1 + p2, en perdant l'information p1 = p2.

Pour ce qui est de l'exécution de l'étape 110, c'est-à-dire la génération des deuxièmes modèles de validation MV', il suffit d'appliquer les résultats obtenus à la troisième étape 204 de la transformation 108 aux propriétés de validation P1, ..., PN. Cela consiste tout simplement à exprimer ces propriétés sous forme de formules logiques, à partir des spécifications techniques 32', le tout dans un langage mathématique. Le langage de la bibliothèque logicielle SMT-LIB étant très proche d'un langage mathématique, il est rapide et aisé d'obtenir les formules mathématiques à vérifier. Celles-ci sont ensuite insérées dans une requête « SMT-LIB template » de la forme suivante, qui permet de demander au solveur SMT si la propriété est valide :

```
 ; Initialisation
(set-logic ALL)(set-option :produce-models true)
  Déclaration des variables
 (declare-const x1 Int) (declare-const x2 Real) ...
 éclaration de l'objectif de preuve
 (assert (not
 [Propriété de validation à vérifier par solveur]
 ))
; Vérification de la propriété
 (check-sat)
```

Dans ce cas précis, l'étape 112 est inutile puisque E2 = E3 et la requête « SMT-LIB template » engendrée (i.e. REQ") est directement exploitable par le solveur SMT choisi, par exemple CVC4. Les étapes 114, 116 et/ou 118 peuvent alors être ensuite exécutées sans difficulté comme expliqué précédemment.

Un deuxième exemple concret d'application de la présente invention va maintenant être détaillé. Il s'agit de pouvoir valider formellement un système physique modélisé dans le langage de modélisation Simulink sous environnement Matlab (i.e. environnement E1) à l'aide d'un solveur SMT, non inclus dans Matlab, sous un environnement de ce solveur compatible avec la bibliothèque logicielle SMT-LIB (i.e. environnement E3 différent de E1).

Le système physique est modélisé dans le langage Simulink au cours de l'étape 100.

Au cours de l'étape 102, l'utilisateur opte pour le solveur SMT non inclus dans Matlab, par exemple S2 ou S3. Les étapes 104 et 106 ne sont alors pas exécutées.

Au cours de l'étape 108, l'ensemble structuré de spécifications techniques 32 exprimées visuellement en blocs fonctionnels dans le langage Simulink sous Matlab est transformé en un ensemble de fonctions à arbres syntaxiques pouvant lui-même être interprété à l'aide de la bibliothèque logicielle SMT-LIB. Comme précédemment, cette transformation est réalisée sous environnement logiciel Python (i.e. l'environnement E2) qui permet de bénéficier de certaines fonctions Matlab.

La première étape de la transformation 108 est une traduction consistant à accéder à l'information des blocs Simulink présents dans l'ensemble structuré de spécifications techniques 32 devant alimenter le script générant celui de la validation formelle. La tâche s'avère à la portée de l'homme du métier à l'aide de la fonction Matlab « find_system » qui permet de trouver l'emplacement de chaque élément de type bloc dans un modèle Simulink. Ensuite, deux autres fonctions « getBlockSimulinkHandle » et « get » sont utilisées pour obtenir toutes les informations de chaque bloc grâce à leur chemin d'accès récupéré au préalable. Les données résultantes sont généralement fournies dans un fichier au format XLS ou équivalent.

Les données utiles sont ensuite extraites dans un fichier au format CSV (de l'anglais « Comma-Separated Values »), ce fichier devant contenir les informations suivantes :
- une case pour un identifiant du bloc (nom du bloc),
- une case indiquant le type de bloc, le type de données (booléen, double, etc.), parfois la ou les valeur(s) d'un ou de plusieurs paramètre(s) fixe(s) du bloc s'il y en a, etc.
- une case indiquant le nombre d'entrées du bloc,
   - une case par entrée contenant son identifiant,
- une case indiquant le nombre de sorties du bloc,
   - une case par sortie contenant son identifiant.

Un exemple de tel fichier est illustré dans la figure 4. En pratique, il est possible de se passer du format XLS et d'extraire directement les données utiles dans le fichier CSV grâce aux fonctions de Matlab.

D'autres aménagements simples de données peuvent être nécessaires tels que :
- redéfinir les identifiants de blocs fonctionnels, plusieurs blocs différents de même type pouvant porter le même nom, en les remplaçant par leurs identifiants numériques uniques ou « handles »,
- supprimer des redondances entre certaines entrées et sorties de blocs fonctionnels différents, sachant que certains blocs peuvent avoir une ou plusieurs entrées connectées à une ou plusieurs sorties d'autres blocs.

Il en résulte un choix arbitraire de lecture des blocs fonctionnels lors de l'extraction des données utiles dans le fichier CSV : par exemple des sorties vers les entrées de chaque bloc. En d'autres termes, il est possible de ne conserver que le nombre d'entrées ainsi que leurs identifiants. Voici alors le nouveau contenu du fichier CSV:
- une case pour un identifiant du bloc (Handle),
- une case indiquant le type de bloc, le type de données (booléen, double, etc.), parfois la valeur de la constante, etc.
- une case indiquant le nombre d'entrées du bloc,
   - une case par entrée contenant son identifiant.

Lorsque le fichier CSV est finalisé, il est à la portée de l'homme du métier d'engendrer automatiquement sous Python, en parcourant le fichier CSV depuis les sorties vers les entrées, la structure d'arbres syntaxiques précitée pour les différentes fonctions des spécifications techniques. En variante, la structure d'arbres syntaxiques pourrait être directement engendrée sous Matlab/Simulink à partir des spécifications techniques 32 sans passer par les formats XLS et CSV, ces formats intermédiaires n'étant utilisés que pour communiquer entre les différents environnements ou langages, en l'occurrence Matlab et Python.

Pour ce qui est de l'exécution de l'étape 110, c'est-à-dire la génération des deuxièmes modèles de validation MV', il suffit d'appliquer les résultats obtenus à la fin de la transformation 108 aux propriétés de validation P1, ..., PN, comme dans l'exemple précédent.

Dans ce cas précis également, l'étape 112 est inutile puisque E2 = E3 et la requête « SMT-LIB template » engendrée (i.e. REQ") est directement exploitable par le solveur SMT choisi, par exemple CVC4. Les étapes 114, 116 et/ou 118 peuvent alors être ensuite exécutées sans difficulté comme expliqué précédemment. En termes d'interface, elles peuvent être lancées par un clic droit sur les spécifications techniques 32 en sélectionnant le solveur SMT choisi. En ce qui concerne plus spécifiquement les étapes 116 et 118, les résultats peuvent être affichés dans la fenêtre de commande de Matlab ou dans une nouvelle fenêtre apparaissant en « pop-up » à la fin de la validation formelle.

Il apparaît clairement qu'un système informatique de validation formelle tel que celui décrit précédemment permet la validation simple et souple d'un système physique en toute indépendance du langage de modélisation dans lequel sont définies ses spécifications techniques.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en oeuvre de l'enseignement qui vient de lui être divulgué.

## Revendications

1. Système informatique (10), pour la validation formelle d'un système physique électronique ou électromécanique définissable par modélisation selon un principe d'ingénierie des systèmes, comportant un processeur (12), des moyens de stockage (14) et une plate-forme logicielle (16) constituée de plusieurs modules fonctionnels (18, 20, 22, 24, 26, 28, 30) stockés dans les moyens de stockage (14) et exécutables par le processeur (12), dans lequel :
- les moyens de stockage (14) comportent un espace de définition du système physique par enregistrement d'un ensemble structuré de spécifications techniques (32) exprimées dans un langage de modélisation prédéterminé ;
- la plate-forme logicielle (16) comporte un module fonctionnel (18) de génération de premiers modèles de validation (MV) à partir de l'ensemble structuré de spécifications techniques (32) et de propriétés de validation (P1, ..., PN) ;
- la plate-forme logicielle (16) comporte un module fonctionnel solveur (20) conçu pour appliquer au moins un solveur (S1, S2, S3) dont une exécution est destinée à fournir un résultat de vérification des propriétés de validation (P1, ..., PN) de l'ensemble structuré de spécifications techniques (32) ; et
- le processeur (12) est conçu pour exécuter ledit au moins un solveur de manière à fournir ledit résultat en vue d'un perfectionnement ou d'une production du système physique électronique ou électromécanique ;
**caractérisé en ce que** :
- le module fonctionnel solveur (20) est conçu pour appliquer au moins un solveur (S2, S3) non applicable aux premiers modèles de validation ;
- pour chaque solveur (S2, S3) non applicable aux premiers modèles de validation, la plate-forme logicielle (16) comporte un module fonctionnel (24, 26) de génération, à partir de l'ensemble structuré de spécifications techniques (32), de requêtes (REQ") exécutables par ce solveur (S2, S3) pour la vérification des propriétés de validation (P1, ..., PN) de l'ensemble structuré de spécifications techniques (32) ; et
- la plate-forme logicielle (16) comporte en outre une interface (UI₂₀), associée au module fonctionnel solveur (20), dédiée à la sélection d'un solveur parmi ledit au moins un solveur (S2, S3) ; et
- le processeur (12) est conçu pour exécuter le solveur sélectionné.

2. Système informatique (10) selon la revendication 1, dans lequel :
- le module fonctionnel solveur (20) est également conçu pour proposer un premier solveur (S1) applicable aux premiers modèles de validation (MV), pour une vérification des propriétés de validation (P1, ..., PN) de l'ensemble structuré de spécifications techniques (32) à partir des premiers modèles de validation (MV) ;
- ce premier solveur (S1) est lui aussi conçu pour fournir un résultat de vérification des propriétés de validation (P1, ..., PN) de l'ensemble structuré de spécifications techniques (32) ; et
- l'interface (UI₂₀) est dédiée à la sélection d'un solveur parmi le premier solveur (S1) et ledit au moins un solveur (S2, S3).

3. Système informatique (10) selon la revendication 2, dans lequel la plate-forme logicielle (16) comporte, pour chaque autre solveur (S2, S3) que le premier solveur (S1), un module fonctionnel (28, 30) de traduction du résultat (RES") de la vérification des propriétés de validation (P1, ..., PN) de l'ensemble structuré de spécifications techniques (32) fourni par cet autre solveur (S2, S3) en un résultat (RES) dans un format tel qui aurait été fourni par le premier solveur (S1) à partir de l'ensemble structuré de spécifications techniques (32) pour la vérification des mêmes propriétés de validation (P1, ..., PN) de l'ensemble structuré de spécifications techniques (32).

4. Système informatique (10) selon l'une quelconque des revendications 1 à 3, dans lequel chaque solveur (S1, S2, S3) est conçu pour produire ledit résultat sous la forme d'une valeur booléenne de vérification de chaque propriété de validation (P1, ..., PN) de l'ensemble structuré de spécifications techniques (32) indiquant si cette propriété de validation est vérifiée ou non pour l'ensemble structuré de spécifications techniques (32).

5. Système informatique (10) selon l'une quelconque des revendications 1 à 4, dans lequel l'ensemble structuré de spécifications techniques (32) est enregistré dans l'espace de définition du système physique sous une forme comportant au moins :
- un dictionnaire d'entrées du système physique prenant chacune la forme d'une paire formée d'une clé et d'une valeur associée à cette clé ; et
- un dictionnaire de sorties du système physique prenant chacune la forme d'une paire formée d'une clé et d'une valeur associée à cette clé, chaque sortie étant en outre associée à une liste d'au moins une relation logique de cause à effet formalisant le respect d'une propriété donnée.

6. Système informatique (10) selon l'une quelconque des revendications 1 à 5, dans lequel pour au moins l'un (S3) dudit au moins un solveur (S2, S3) non applicable aux premiers modèles de validation, le module fonctionnel (26) de génération, à partir de l'ensemble structuré de spécifications techniques (32), de requêtes (REQ") exécutables par ce solveur (S3) pour la vérification des propriétés de validation (P1, ..., PN) de l'ensemble structuré de spécifications techniques (32) comporte :
- un sous-module fonctionnel (26A) de traduction des spécifications techniques (32) dans un format commun d'interprétation prédéterminé autre que le langage de modélisation prédéterminé ;
- un sous-module fonctionnel (26B) de génération de deuxièmes modèles de validation (MV') à partir de l'ensemble structuré de spécifications techniques (32') exprimées dans le format commun d'interprétation prédéterminé et des propriétés de validation (P1, ..., PN) ; et le cas échéant
- un sous-module fonctionnel (26C) de génération, à partir des deuxièmes modèles de validation (MV'), desdites requêtes (REQ") exécutables par ce solveur (S3) pour la vérification des propriétés de validation (P1, ..., PN) de l'ensemble structuré de spécifications techniques (32).

7. Système informatique (10) selon l'une quelconque des revendications 1 à 6, dans lequel pour au moins l'un (S2) dudit au moins un solveur (S2, S3) non applicable aux premiers modèles de validation, le module fonctionnel (24) de génération, à partir de l'ensemble structuré de spécifications techniques (32), de requêtes (REQ") exécutables par ce solveur (S2) pour la vérification des propriétés de validation (P1, ..., PN) de l'ensemble structuré de spécifications techniques (32) comporte :
- un sous-module fonctionnel (24A) de transformation de l'ensemble structuré de spécifications techniques (32) exprimées dans le langage de modélisation prédéterminé en un ensemble d'équations à arbres syntaxiques ; et
- un sous-module fonctionnel (24B) de génération, à partir de l'ensemble d'équations à arbres syntaxiques, desdites requêtes (REQ") exécutables par ce solveur (S2) pour la vérification des propriétés de validation (P1, ..., PN) de l'ensemble structuré de spécifications techniques (32).

8. Système informatique (10) selon la revendication 7, dans lequel le sous-module fonctionnel de transformation (24A) comporte un analyseur logiciel syntaxique et lexical.

9. Système informatique (10) selon la revendication 8, dans lequel le module fonctionnel (24) de génération de requêtes (REQ") exécutables par ce solveur (S2) est implémenté en langage de programmation Python et l'analyseur syntaxique et lexical comporte l'outil Python Lex-Yacc.

10. Procédé de validation formelle d'un système physique électronique ou électromécanique définissable par modélisation selon un principe d'ingénierie des systèmes, comportant les étapes suivantes :
- modélisation (100) du système physique par enregistrement, dans un espace de définition du système physique inclus dans des moyens de stockage (14), d'un ensemble structuré de spécifications techniques (32) exprimées dans un langage de modélisation prédéterminé ;
- réception, par une plate-forme logicielle (16) exécutée par un processeur (12) ayant accès aux moyens de stockage (14), de l'ensemble structuré de spécifications techniques (32) ;
- sélection (102), à l'aide d'une interface dédiée (UI₂₀) associée à un module fonctionnel solveur (20) de la plate-forme logicielle (16), d'un solveur conçu pour fournir un résultat de vérification des propriétés de validation (P1, ..., PN) de l'ensemble structuré de spécifications techniques (32) parmi :
• un éventuel premier solveur (S1) de vérification des propriétés de validation (P1, ..., PN) de l'ensemble structuré de spécifications techniques (32) à partir de premiers modèles de validation (MV), et
• au moins un autre solveur (S2, S3), non applicable aux premiers modèles de validation, pour lequel la plate-forme logicielle (16) comporte un module fonctionnel (24, 26) de génération (108, 110), à partir de l'ensemble structuré de spécifications techniques (32), de requêtes (REQ") exécutables par cet autre solveur (S2, S3) pour la vérification des propriétés de validation (P1, ..., PN) de l'ensemble structuré de spécifications techniques (32) ;
- génération (104), par un module fonctionnel (18) de la plate-forme logicielle (16), des premiers modèles de validation (MV) à partir de l'ensemble structuré de spécifications techniques (32) et de propriétés de validation (P1, ..., PN) au moins lorsque l'éventuel premier solveur (S1) est sélectionné ; et
- exécution (114) du solveur sélectionné pour la fourniture du résultat de vérification des propriétés de validation (P1, ..., PN) de l'ensemble structuré de spécifications techniques (32) en vue d'un perfectionnement ou d'une production du système physique électronique ou électromécanique.

11. Programme d'ordinateur (16) téléchargeable depuis un réseau de communication et/ou enregistré sur un support (14) lisible par ordinateur (10) et/ou exécutable par un processeur (12), **caractérisé en ce qu'**il comprend des instructions (18, 20, 22, 24, 26, 28, 30) pour l'exécution des étapes d'un procédé de validation formelle d'un système physique selon la revendication 10, lorsque ledit programme (16) est exécuté sur un ordinateur (10).
